**Europäisches Patentamt**

**European Patent Office**

**Office européen des brevets**

(19)

(11) Numéro de publication : **0 297 963 B1**

(12) **FASCICULE DE BREVET EUROPEEN**

(45) Date de publication du fascicule du brevet :
**27.11.91 Bulletin 91/48**

(51) Int. Cl.$^5$ : **H01L 21/60**

(21) Numéro de dépôt : **88401625.4**

(22) Date de dépôt : **27.06.88**

(54) **Procédé de connexion par laser d'un conducteur à une région dopée du substrat d'un circuit intégré, et circuit intégré mettant en oeuvre le procédé.**

(30) Priorité : **02.07.87 FR 8709383**

(43) Date de publication de la demande :
**04.01.89 Bulletin 89/01**

(45) Mention de la délivrance du brevet :
**27.11.91 Bulletin 91/48**

(84) Etats contractants désignés :
**CH DE ES FR GB IT LI NL SE**

(56) Documents cités :
**IBM TECHNICAL DISCLOSURE BULLETIN,
vol. 17, no. 1, juin 1974, page 248, New York,
US; F.M. D'HEURLE et al.: "Lowering the laser
formed contact resistance between A1 and
Si"
IBM TECHNICAL DISCLOSURE BULLETIN,
vol. 21, no. 6, novembre 1978, pages
2549-2550, New York, US; P. CHAUDHARI et
al.: "Bonding wires to microcircuitry"**

(73) Titulaire : **BULL S.A.
121, Avenue de Malakoff
F-75116 Paris (FR)**

(72) Inventeur : **Boudou, Alain
25, avenue de la Grande Armée
F-75016 Paris (FR)**
Inventeur : **Bonnal, Marie-Françoise
25, avenue de la Grande Armée
F-75016 Paris (FR)**
Inventeur : **Rouillon-Martin, Martine
25, avenue de la Grande Armée
F-75016 Paris (FR)**

(74) Mandataire : **Denis, Hervé et al
BULL S.A. Industrial Property Department
P.C.: HQ 8M006 P.B. 193.16 121 avenue de
Malakoff
F-75764 Paris Cédex 16 (FR)**

## Description

L'invention se rapporte à un procédé de connexion par laser d'un conducteur à une région dopée du substrat d'un circuit intégré et au circuit intégré mettant en oeuvre ce procédé.

Un circuit intégré, appelé couramment chip ou puce, est essentiellement un substrat semiconducteur incorporant des régions dopées pour la constitution des composants électroniques et portant un réseau d'interconnexion de ces composants. Le réseau d'interconnexion repose sur le substrat par l'intermédiaire d'une couche diélectrique de dioxyde de silicium (SiO2) formée par croissance du matériau du substrat. La couche diélectrique est généralement mince au-dessus des régions dopées, de l'ordre de quelques dizaines de nanomètres, et épaisse entre ces régions (de plusieurs centaines de nanomètres). Le réseau d'interconnexion se compose couramment de plusieurs couches conductrices séparées par des couches d'isolation et reliées entre elles en certains points par des piliers (vias) traversant les couches d'isolation. Chaque couche conductrice se compose de nombreux conducteurs parallèles entre eux dans une direction orthogonale aux conducteurs d'une couche conductrice voisine. Des conducteurs de la couche inférieure sont connectés aux régions correspondantes du substrat par l'intermédiaire d'ouvertures ménagées dans la couche diélectrique mince qui recouvre ces régions.

La technique actuelle de fabrication ou de conception des circuits intégrés de haute densité appelés encore puces VLSI (Very Large Scale Integration chips) tente d'appliquer à grande échelle le laser pour modifier les circuits de ces puces. Notamment, la modification des circuits d'une puce est faite pour corriger certains défauts de connexion. Des connexions par laser sont alors programmées pour la reconfiguration d'un circuit à cause d'un défaut, ou pour le branchement d'un circuit de substitution à un circuit défaillant conformément à la technique dite de redondance des blocs fonctionnels d'un circuit intégré. D'autre part, la modification des circuits intégrés dans une puce intervient naturellement lorsque la puce est ou inclut une mémoire morte programmable (Programmable Read-Only Memory). L'état de conduction des cellules de la mémoire est déterminé par une ou plusieurs connexions entre des éléments conducteurs prédéterminés de chaque cellule. L'emploi du laser est une solution envisagée pour programmer une mémoire morte. En conclusion, la programmation par laser des connexions dans les circuits intégrés d'une puce a de nombreuses applications et présente de nombreux avantages.

Plusieurs procédés sont actuellement connus pour faire en un point, au moyen d'un faisceau laser, la connexion électrique de deux éléments conducteurs superposés d'un circuit intégré ou entre un conducteur et une région du substrat au travers de la *couche diélectrique mince.*

Un procédé connu de liaison programmable par laser de deux conducteurs superposés est décrit notamment dans l'article de N. S. Platakis dans la revue "Journal of Applied Physics", Vol. 47, n°5, Mai 1976, pages 2120-2128. Au point de liaison souhaité, on applique un faisceau laser dont l'énergie, le diamètre, le nombre et la durée des impulsions sont déterminés de façon à ouvrir progressivement le conducteur supérieur, puis la couche diélectrique et en partie le conducteur inférieur, et à former un contact entre les deux conducteurs par éjections du matériau fondu du conducteur inférieur jusqu'au niveau du conducteur supérieur. Les deux conducteurs sont donc connectés entre eux par les éjections solidifiées sur les parois d'un cratère qui a ainsi la forme approximative d'un trou métallisé. Ce procédé a de nombreux inconvénients.

D'abord on comprend que les éjections incontrôlables du matériau fondu du conducteur inférieur placé sous un faisceau laser dans des conditions identiques donne des configurations différentes de la liaison des conducteurs dans chaque cratère. Il s'ensuit que les liaisons formées par ce procédé dans des conditions identiques présentent différentes qualités de connexion électrique. La pratique confirme les défauts de répétitivité et de fiabilité de ce procédé.

Comme second inconvénient, la formation d'un cratère impose l'utilisation d'un faisceau laser puissant et endommage la structure des deux éléments conducteurs et de la couche isolante qui les sépare. D'une part, le choc thermique peut créer des défauts électriques sur les éléments actifs (jonctions, transistors,...) qui avoisinent le cratère. D'autre part, le choc thermique crée une dislocation de la structure des éléments conducteurs, qui est particulièrement indésirable lorsque l'élément conducteur inférieur est une région dopée d'un substrat de silicium. Même lorsque l'élément inférieur est un conducteur du réseau d'interconnexion, cet élément doit avoir une épaisseur minimale pour ne pas endommager la couche d'isolation qui le sépare du substrat. Par conséquent, la connexion par laser sous forme de cratère n'est en pratique qu'appliquée à la connexion de deux éléments conducteurs du réseau d'interconnexion formé au-dessus d'un substrat de silicium. Il s'ensuit que pour la connexion souhaitée entre un conducteur supérieur et une région dopée du substrat, il faut relier cette région à un conducteur intermédiaire avec lequel le conducteur supérieur sera connecté par un cratère suffisamment éloigné de la région dopée du substrat.

Ce mode de connexion a aussi pour inconvénient de ne pas pouvoir se faire après la fabrication du circuit intégré. En effet, la fabrication d'un circuit intégré se termine par le recouvrement de l'ensemble du réseau d'interconnexion par une couche épaisse de passivation adaptée pour protéger le circuit intégré électriquement, mécaniquement et chimiquement. On comprend alors que la connexion par laser ne peut être faite correctement qu'avant le dépôt de la couche de passivation, c'est-à-dire pendant le processus de fabrication du circuit intégré. Cet inconvénient se traduit par un manque de souplesse de la programmation des liaisons dans le circuit intégré et par une augmentation des coûts.

Enfin, la connexion en un point par laser sous forme de cratère est facilement observable au microscope optique et peut renseigner un observateur sur toute la configuration des connexions faites sur un circuit intégré. Ce mode de connexion ne peut donc pas être utilisé lorsque les connexions se réfèrent à des informations confidentielles ou que l'on veut inviolables, comme c'est le cas par exemple pour les mémoires à circuits intégrés de cartes de crédit (smart cards).

Un autre procédé connu pour la liaison programmable par laser de deux conducteurs superposés est décrit notamment dans l'article de J. I. Raffel et al., intitulé "Laser Programmed Vias for Restructurable VLSI" dans la publication "Technical Digest of the International Electron Devices Meeting, 1980" pages 132-135. Ce procédé consiste à utiliser du silicium amorphe dans la couche diélectrique au niveau du point de liaison. L'emploi de silicium amorphe en des endroits prédéterminés de la couche diélectrique a l'inconvénient de compliquer le procédé de fabrication du circuit intégré et d'interdire la programmation de toutes liaisons par laser en dehors de ces endroits.

L'invention présente un procédé de connexion par laser d'un élément conducteur à une région dopée du substrat d'un circuit intégré, qui a l'avantage sur les procédés antérieurs d'être simple, fiable et efficace, avec un laser peu puissant, applicable pendant et après la fabrication du circuit intégré, et de ne laisser pratiquement aucune trace décelable au microscope de la connexion réalisée.

Le procédé conforme à l'invention de connexion électrique par laser d'un conducteur à une région dopée du substrat d'un circuit intégré par l'intermédiaire d'une couche diélectrique mince est caractérisé en ce qu'il consiste à disposer un bord du conducteur au-dessus de la région, à faire chevaucher le faisceau laser sur le bord du conducteur et la région et à régler la puissance, le diamètre, le nombre et la durée des impulsions du faisceau laser de manière à créer définitivement en une zone de la couche diélectrique des défauts lui conférant une faible résistance électrique.

Un circuit intégré mettant en oeuvre ce procédé comprend un substrat pourvu d'au moins une région dopée sous-jacente à un conducteur par l'intermédiaire d'une couche diélectrique mince et se caractérise par le fait que le conducteur présente un bord à la région du substrat. Cette caractéristique permet l'application du procédé conforme à l'invention pour former définitivement dans la couche diélectrique, au niveau du bord conducteur, une zone de connexion de faible résistance électrique.

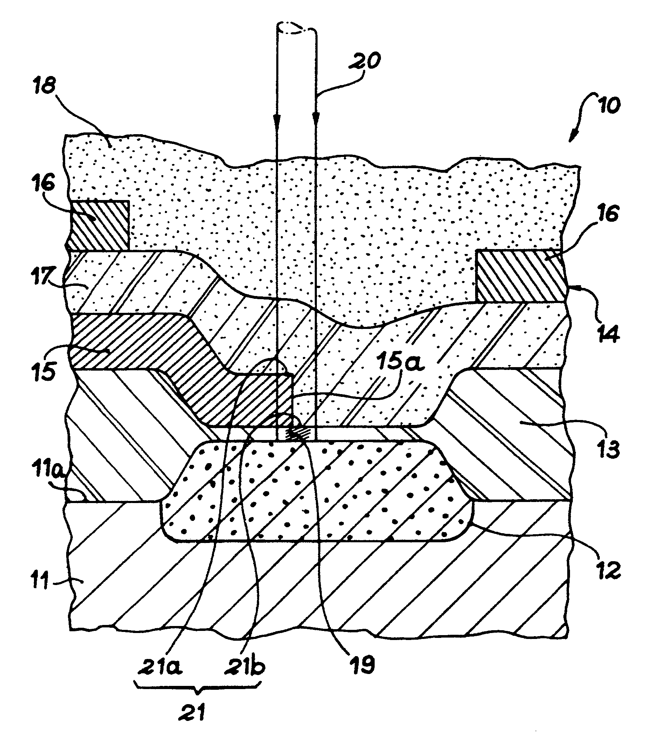

Les caractéristiques et avantages de l'invention ressortiront de la description qui suit, donnée à titre d'exemple et faite en référence à la figure des dessins annexés, qui représente par une vue en coupe transversale d'un circuit intégré la connexion par laser conforme à l'invention d'un conducteur du réseau d'interconnexion à une région dopée du substrat semiconducteur du circuit intégré.

En référence à la figure, le circuit intégré (10) comprend essentiellement un substrat semiconducteur monocristallin (11), en silicium généralement, dont la face supérieure (11a) comporte des régions dopées (12). La figure est une vue en coupe partielle du circuit intégré (10) au niveau d'une région dopée (12). Dans la figure, les proportions des longueurs n'ont pas été respectées pour la clarté des dessins et seront rectifiées à l'évidence par l'homme du métier. Une couche diélectrique (13) de dioxyde de silicium (SiO2) est formée par oxydation du silicium du substrat (11) sur toute sa face (11a). Au niveau des régions dopées (12), la couche diélectrique est ordinairement très mince, de l'ordre de quelques dizaines de nanomètres. Sur la couche diélectrique (13) est formé un réseau (14) d'interconnexion des régions (12) du substrat (11). De manière classique, le réseau (14) illustré se compose de conducteurs inférieurs (15) et supérieurs (16) séparés entre eux par une couche isolante (17). Les conducteurs inférieurs (15) peuvent être métalliques, en aluminium ordinairement, ou être faits de silicium polycristallin, appelé aussi polysilicium, dûment dopés pour être conducteurs, ou encore être un alliage métal-silicium. Les conducteurs supérieurs (16) sont habituellement en métal tel que l'aluminium. L'exemple illustré se rapportant à l'utilisation de l'invention après fabrication du circuit intégré (10), celui-ci est donc pourvu d'une couche de passivation (18) recouvrant le réseau d'interconnexion (14) pour le protéger électriquement, mécaniquement et chimiquement. La couche de passivation (18) est ordinairement faite d'un verre dopé en phosphore.

Pour faire la connexion (19) d'un conducteur (15) à une région (12) au moyen d'un faisceau laser (20), le procédé conforme à l'invention consiste d'abord à disposer un bord du conducteur (15) au-dessus de la région (12). Dans l'exemple illustré, c'est l'extrémité (15a) du conducteur (15) qui est présentée à la région (12) et qui est donc considérée comme bord concerné par l'invention. Ce peut être cependant un bord longitudinal du conducteur. Le procédé consiste ensuite à utiliser un faisceau laser (20) ayant un diamètre D, une puissance P et de durée d'impulsion T. Le faisceau laser (20) est dirigé orthogonalement à la face supérieure (11a) du substrat (11), de façon que sa zone d'impact (21) se partage en une zone (21a) sur le bord (15a) du conducteur (15) et en une zone (21b) sur la couche diélectrique (13). La zone d'impact (21) est donc amenée à chevaucher le conducteur (15) et la couche diélectrique (13) dans la région (12). Enfin, on ajuste la puissance P̱, le diamètre Ḏ, le nombre Ṉ et la durée Ṯ des impulsions du faisceau laser (20) de façon à créer définitivement en la zone (19) de la couche diélectrique des défauts lui conférant une faible résistance électrique. La zone de connexion (19) correspond sensiblement à la zone (21) couverte par le faisceau (20). La faible résistance électrique obtenue dans diverses conditions expérimentales s'étale dans une marge comprise entre environ 100 ohms et quelques kiloohms, et plus particulièrement entre 300 ohms et 3 kiloohms.

A titre d'exemple, l'expérience typique suivante a été faite avec un circuit intégré dont la couche diélectrique (13) de dioxyde de silicium avait une épaisseur de 70 nm, la région (12) avait une profondeur de 400 nm, le conducteur en polysilicium (15) avait une épaisseur de 500 nm et la couche isolante qui la recouvrait faisait approximativement 1 micromètre d'épaisseur. Le faisceau laser (20) avait un diamètre D = 5 micromètres et a délivré une puissance P = 0,76 Watt pendant une seule impulsion (N = 1) de durée T = 1 ms. La résistance mesurée entre le conducteur (15) et la région (12) s'élevait à environ 350 ohms.

La valeur de la résistance de la connexion (19) dépend des paramètres d'utilisation du faisceau, des dimensions des éléments traversés par le faisceau et de leur nature. Un conducteur (15) en métal convient. Cependant, il a été observé que si le conducteur (15) est fait de silicium polycristallin dopé d'un type donné, la connexion (19) conforme à l'invention ne peut exister que si la région (12) et le conducteur (15) ont le même type de dopage. Il faut donc sélectionner en conséquence le type de dopage du conducteur (15) en polysilicium, ou trouver sur le substrat une région adéquate déjà existante pour obtenir une connexion (19) conforme à l'invention, ou bien créer une telle région, ou encore adjoindre au conducteur (15) un conducteur métallique qui permet de faire la connexion (19).

Le premier avantage de l'invention est de faire simplement une connexion fiable et efficace avec un faisceau laser de très faible énergie par rapport à l'énergie indispensable pour former un cratère conformément à la technique antérieure.

Le second avantage de l'invention réside dans le fait que la zone de connexion (19) conforme à l'invention est pratiquement inobservable au microscope optique. On suppose donc que la faible énergie apportée par le faisceau laser est utilisée par la couche diélectrique mince (13) pour créer avec la matière conductrice environnante des défauts définitifs invisibles mais suffisants pour obtenir une faible résistance électrique. Il a été constaté que la zone de connexion (19) ne s'étend que dans la couche diélectrique mince et n'altère pratiquement pas, sous un microscope optique, les éléments conducteurs reliés conformément à l'invention.

Le troisième avantage de l'invention est de réaliser une connexion indépendamment des éléments conducteurs et isolants 15, 16, 17, 18 qui recouvrent successivement la couche diélectrique mince. Etant donné qu'il suffit d'une très faible énergie au niveau de cette couche, l'énergie à la sortie du laser, qui tient compte de l'absorption d'énergie dans les éléments précédents, demeure faible.

Elle est et en tout cas insuffisante pour que l'énergie absorbée dans ces éléments puisse modifier leur nature ou leur structure.

D'autre part, il est à noter que les composants du circuit intégré peuvent être faits de régions dopées du substrat et de conducteurs formés au-dessus du substrat, au voisinage de ces régions et par l'intermédiaire de couches diélectriques minces. C'est le cas par exemple des transistors MOS (Métal Oxyde Semi-conducteur) dont la grille est faite d'une bande conductrice s'étalant au-dessus du substrat et séparant les deux régions dopées de drain et de source du substrat. Le conducteur de grille peut être métallique ou en silicium polycristallin fortement dopé. Un tel conducteur est aussi concerné par l'invention. Par exemple, en prolongeant la grille d'un transistor MOS, l'invention permet de connecter par laser la grille directement à une région voisine indépendante ou constitutive d'un autre composant.

On comprend maintenant que l'application de l'invention à la programmation par laser de connexions de circuits intégrés est très avantageuse et très étendue. Notamment, la programmation par laser conforme à l'invention sera très appréciée pour la correction des circuits intégrés dans les puces VLSI ou pour la programmation de mémoires mortes.

## Revendications

1. Procédé de connexion électrique par laser d'un conducteur (15) à une région dopée (12) du substrat (11) d'un circuit intégré (10) par l'intermédiaire d'une couche diélectrique mince (13), caractérisé en ce qu'il consiste à disposer un bord (15a) du conducteur au-dessus de la région, à faire chevaucher (21a, 21b) le faisceau laser (20) sur le bord du conducteur et sur la région, et à régler la puissance (P), le diamètre (D), le nombre (N) et la durée (T) des impulsions du faisceau laser de manière à créer définitivement en une zone (19) de la couche diélectrique des défauts lui conférant une faible résistance électrique.

2. Procédé selon la revendication 1, caractérisé en ce que le conducteur est métallique.

3. Procédé selon la revendication 1 ou 2, caractérisé en ce que le conducteur contient du silicium polycristallin dopé du même type que la région.

4. Circuit intégré (10) comprenant un substrat (11) pourvu d'au moins une région dopée (12) sous-jacente à un conducteur (15) et séparée de celui-ci par une couche diélectrique mince (13), caractérisé en ce que la connexion électrique entre le conducteur (15) et la région dopée (12) est réalisée sur le bord (15a) du conducteur selon le procédé défini par la revendication 1, 2 ou 3.

5. Circuit intégré selon la revendication 4, caractérisé en ce que la couche diélectrique (13) au niveau du bord présente une zone de connexion (19) de faible résistance électrique.

6. Circuit intégré selon la revendication 4 ou 5, caractérisé en ce que le conducteur est métallique.

7. Circuit intégré selon la revendication 4, 5 ou 6, caractérisé en ce que le conducteur contient du silicium polycristallin dopé du même type que la région.

8. Circuit intégré selon l'une des revendications 4 à 7, caractérisé en ce que le conducteur est un élément du réseau d'interconnexion (14).

9. Circuit intégré selon l'une des revendications 4 à 7, caractérisé en ce que le conducteur est un élément d'un composant du circuit intégré.

10. Circuit intégré selon l'une des revendications 4 à 9, caractérisé en ce que le circuit intégré est pourvu du réseau de connexion complet (14) et éventuellement de la couche de passivation (18).

11. Circuit intégré selon l'une des revendications 4 à 10, caractérisé en ce qu'il incorpore une mémoire morte programmable.

12. Circuit intégré selon l'une des revendications 4 à 11, caractérisé en ce qu'il incorpore des moyens de correction des circuits contenus dans le circuit intégré.

**Patentansprüche**

1. Verfahren zur lasergestützten Herstellung einer elektrischen Verbindung eines Leiters (15) mit einem dotierten Gebiet (12) des Substrats (11) einer integrierten Schaltung (10) mittels einer dünnen dielektrischen Schicht (13), dadurch gekennzeichnet, daß es die Anordnung eines Randes (15a) des Leiters oberhalb des Gebiets, die Überlappung (21a, 21b) des Laserstrahls (20) mit dem Rand des Leiters und dem Gebiet und die Einstellung der Leistung (P), des Durchmessers (D), der Anzahl (N) und der Dauer (T) der Impulse des Laserstrahls umfaßt, derart, daß in einer Zone (19) der dielektrischen Schicht endgültig Fehlstellen erzeugt werden, die ihr einen geringen elektrischen Widerstand verleihen.

2. Verfahren gemäß Anspruch 1, dadurch gekennzeichnet, daß der Leiter aus Metall ist.

3. Verfahren gemäß Anspruch 1 oder 2, dadurch gekennzeichnet, daß der Leiter polykristallines Silizium enthält, das mit dem gleichen Typ wie das Gebiet dotiert ist.

4. Integrierte Schaltung (10), mit einem Substrat (11), das mit wenigstens einem dotierten Gebiet (12) versehen ist, das sich unter einem Leiter (15) befindet und von diesem durch eine dünne dielektrische Schicht (13) getrennt ist, dadurch gekennzeichnet, daß die elektrische Verbindung zwischen dem Leiter (15) und dem dotierten Gebiet (12) an dem Rand (15a) des Leiters gemäß dem Verfahren gemäß den Ansprüchen 1, 2 oder 3 verwirklicht wird.

5. Integrierte Schaltung gemäß Anspruch 4, dadurch gekennzeichnet, daß die dielektrische Schicht (13) auf Höhe des Randes eine Verbindungszone (19) mit geringem elektrischen Widerstand aufweist.

6. Integrierte Schaltung gemäß Anspruch 4 oder 5, dadurch gekennzeichnet, daß der Leiter aus Metall ist.

7. Integrierte Schaltung gemäß Anspruch 4, 5 oder 6, dadurch gekennzeichnet, daß der Leiter polykristallines Silizium enthält, das mit dem gleichen Typ wie das Gebiet dotiert ist.

8. Integrierte Schaltung gemäß einem der Ansprüche 4 bis 7, dadurch gekennzeichnet, daß der Leiter ein Element des Verdrahtungsnetzes (14) ist.

9. Integrierte Schaltung gemäß einem der Ansprüche 4 bis 7, dadurch gekennzeichnet, daß der Leiter ein Element eines Bauteils der integrierten Schaltung ist.

10. Integrierte Schaltung gemäß einem der Ansprüche 4 bis 9, dadurch gekennzeichnet, daß die integrierte Schaltung mit dem vollständigen Verdrahtungsnetz (14) und eventuell mit der Passivierungsschicht (18) versehen ist.

11. Integrierte Schaltung gemäß einem der Ansprüche 4 bis 10, dadurch gekennzeichnet, daß sie einen programmierbaren Festwertspeicher umfaßt.

12. Integrierte Schaltung gemäß einem der Ansprüche 4 bis 11, dadurch gekennzeichnet, daß sie Korrekturmittel für die in der integrierten Schaltung enthaltenen Schaltungen umfaßt.

**Claims**

1. Method of electrical connection by laser of a conductor (15) to a doped region (12) of the substrate (11) of an integrated circuit (10) through the medium of a thin dielectric layer (13), characterised in that it consists in disposing one edge (15a) of the conductor above the region, causing the laser beam (20) to overlap (21, 21b) the edge of the conductor and the region, and regulating the power (P), the diameter (D), the number (N) and duration (T) of the pulses of the laser beam such as to definitively create faults in a zone (19) of the dielectric layer which give it a low electrical resistance.

2. Method according to claim 1, characterised in that the conductor is of metal.

3. Method according to claim 1 or 2, characterised in that the conductor contains doped polycrystalline silicon of the same type as the region.

4. An integrated circuit (10) comprising a substrate (11) having at least one doped region (12) subjacent to a conductor (15) and separated from the latter by a thin dielectric layer (13), characterised in that the electrical connection between the conductor (15) and the doped region (12) is effected on the edge (15a) of the conductor according to the method defined by claim 1, 2 or 3.

5. Integrated circuit according to claim 4, characterised in that the dielectric layer (13) at the level of the edge has a connection zone (19) of low electrical resistance.

6. Integrated circuit according to claim 4 or 5, characterised in that the conductor is of metal.

7. Integrated circuit according to claim 4, 5 or 6, characterised in that the conductor contains doped polycrystalline silicon of the same type as the region.

8. Integrated circuit according to one of the claims 4 to 7, characterised in that the conductor is an element of the interconnection network (14).

9. Integrated circuit according to one of claims 4 to 7, characterised in that the conductor is an element of a component of the integrated circuit.

10. Integrated circuit according to one of claims 4 to 9, characterised in that the integrated circuit is provided with a complete interconnection network (14) and possibly with a passivation layer (18).

11. Integrated circuit according to one of claims 4 to 10, characterised in that it includes a programmable read only memory.

12. Integrated circuit according to one of claims 4 to 11, characterised in that it incorporates means for correction of the circuits contained in the integrated circuit.